# EUROPEAN PATENT APPLICATION

(11) **EP 4 608 107 A2**
(43) Date of publication of application: **27.08.2025**
(21) Application number: 25189618.9
(22) Date of filing: 31.07.2013
(51) Int. Cl.: H10K 59/00

(54) **PIXEL ARRANGEMENT STRUCTURE FOR ORGANIC LIGHT EMITTING DIODE DISPLAY**

(30) Priority: 13.09.2012 US 201213614197; 23.04.2013 KR 20130044993
(62) Divisional of application: 20199618.8
(71) Applicant: Samsung Display Co., Ltd., Yongin-si, Gyeonggi-do 17113 (KR)
(72) Inventor: Lee, Sang Shin, Hwaseong-si, Gyeonggi-do (KR)
(74) Representative: Gulde & Partner

(57) **Abstract**

A pixel arrangement structure of an organic light emitting diode (OLED) display is provided. The pixel arrangement structure includes: a first pixel (100) having a center coinciding with a center of a virtual square (VS); a second pixel (200) separated from the first pixel (100) and having a center at a first vertex (P1) of the virtual square (VS); and a third pixel (300) separated from the first pixel (100) and the second pixel (200), and having a center at a second vertex (P2) neighboring the first vertex (P1) of the virtual square (VS). The first pixel (100), the second pixel (200), and the third pixel (300) have polygonal shapes, wherein the first pixel (100) has an octagonal shape, and at least one of the second pixel (200) and the third pixel (300) has a hexagonal shape.

## Description

### BACKGROUND

### 1. Field

Aspects of embodiments of the present invention relate generally to a pixel arrangement structure for an organic light emitting diode (OLED) display.

### 2. Description of the Related Art

A display device is a device that displays an image. Recently, an OLED display has been drawing attention.

The OLED display has a self-luminous characteristic. Because the OLED display does not need a separate light source, unlike a liquid crystal display, it can have a relatively smaller thickness and weight than liquid crystal displays. In addition, the OLED display exhibits high-quality characteristics such as low power consumption, high luminance, high response speed, etc.

In general, the OLED display includes a plurality of pixels for emitting light of different colors. The plurality of pixels emit light to display an image.

Here, the pixel refers to a minimum unit for displaying the images. For instance, there may be a gate line, a data line, and a power line such as a driving power line to drive each pixel. In addition, there may be an insulation layer such as a pixel definition layer to define an area and a shape of each pixel. Further, each pixel may be positioned between its neighboring pixels.

An organic emission layer included in the pixel of an OLED display may be deposited and formed by using a mask such as a fine metal mask (FMM). When reducing a gap between the neighboring pixels to obtain a high aperture ratio of the pixels, deposition reliability may be deteriorated. On the other hand, when increasing the gap between the pixels to improve the deposition reliability, the aperture ratio of the pixels may be deteriorated.

The above information disclosed in this Background section is only for enhancement of understanding of the background of the invention and therefore it may contain information that does not form the prior art that is already known in this country to a person of ordinary skill in the art.

### SUMMARY

Aspects of embodiments of the present invention relate generally to a pixel arrangement structure for an OLED display. More particularly, aspects of embodiments of the present invention relate to a pixel arrangement structure of an OLED display that displays an image by emitting light through a plurality of pixels.

An exemplary embodiment of the present invention provides a pixel arrangement structure for an OLED display having an improved aperture ratio of each of the pixels while efficiently setting up gaps between the pixels.

According to an exemplary embodiment of the present invention, a pixel arrangement structure of an organic light emitting diode (OLED) display is provided. The pixel arrangement structure includes: a first pixel having a center coinciding with a center of a virtual square; a second pixel separated from the first pixel and having a center at a first vertex of the virtual square; and a third pixel separated from the first pixel and the second pixel, and having a center at a second vertex neighboring the first vertex of the virtual square. The first pixel, the second pixel, and the third pixel have polygonal shapes. The first pixel has an octagonal shape, and at least one of the second pixel or the third pixel has a hexagonal shape.

In one embodiment, the second pixel includes a pair of second pixels, and the second pixels are separated from each other by the first pixel.

In one embodiment, the third pixel includes a pair of third pixels, and the third pixels are separated from each other by the first pixel.

In one embodiment, the second pixel includes a pair of second pixels, the third pixel includes a pair of third pixels, and the second pixels and the third pixels enclose the first pixel in the virtual square.

In one embodiment, each of the second pixels and the third pixels is larger in area than the first pixel.

In one embodiment, at least one of the second pixel or the third pixel has an octagonal shape.

In one embodiment, one of the second pixel and the third pixel has a hexagonal shape and the other one of the second pixel and the third pixel has a quadrilateral shape.

In one embodiment, the virtual square includes a pair of virtual squares sharing a common side, the first pixel includes a pair of first pixels having centers respectively coinciding with centers of the virtual squares, and the first pixels have octagonal shapes that are symmetrical to each other.

In one embodiment, each of the second pixels is larger in area than each of the third pixels.

In one embodiment, a distance between the first pixel and the second pixels as well as a distance between the first pixel and the third pixels is a same first length.

In one embodiment, the virtual square includes a pair of virtual squares sharing a common side, the first pixel includes a pair of first pixels having centers respectively coinciding with centers of the virtual squares, a distance between each of the second pixels and the third pixels is a same second length, and a distance between the first pixels is a third length that is longer than the first length and the second length.

In one embodiment, the first pixel, the second pixel, and the third pixel are configured to emit light of different color.

In one embodiment, the first pixel is configured to emit green light, one of the second pixel and the third pixel is configured to emit blue light, and the other one of the second pixel and the third pixel is configured to emit red light.

According to an exemplary embodiment of the present invention, the pixel arrangement structure of the OLED display improves the aperture ratio of the pixels while efficiently setting up the gaps between the pixels.

### BRIEF DESCRIPTION OF THE DRAWING

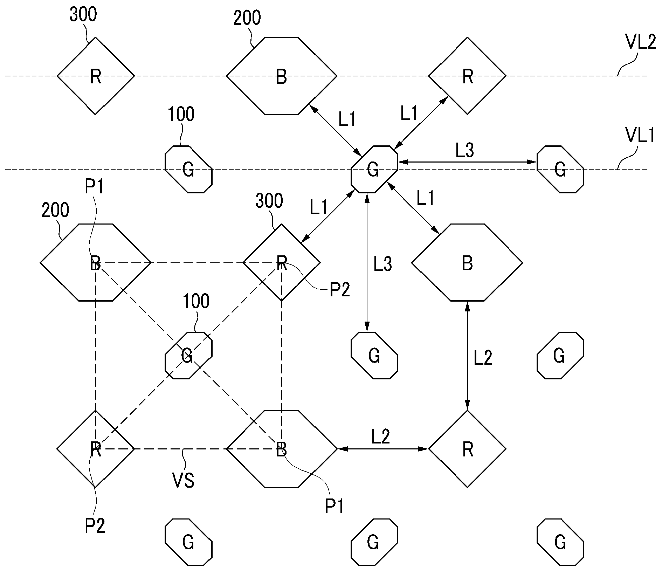

Fig. 1 is a view of a pixel arrangement structure of an OLED display according to an exemplary embodiment of the present invention.

### DETAILED DESCRIPTION

Several exemplary embodiments according to the present invention are described hereinafter in detail with reference to the accompanying drawing to allow one of ordinary skill in the art to practice the invention without undue experimentation. The present invention can be embodied in several different forms, and is not limited to the exemplary embodiments that are described herein.

In order to clarify the description of embodiments of the present invention, parts that are not related to the invention may be omitted. In addition, the same elements or equivalents are referred to with the same reference numerals throughout the specification.

Further, since sizes and thicknesses of constituent members shown in the accompanying drawing may be arbitrarily given for better understanding and ease of description, the present invention is not limited to the illustrated sizes and thicknesses.

In addition, unless explicitly described to the contrary, the word "comprise" and variations such as "comprises" or "comprising" will be understood to imply the inclusion of stated elements but not the exclusion of any other elements.

Hereinafter, a pixel arrangement structure (or pixel arrangement) of an OLED display according to an exemplary embodiment will be described with reference to Fig. 1. The drawing is a view schematically showing a portion of pixels forming an OLED display.

Fig. 1 shows a pixel arrangement structure of an OLED display according to an exemplary embodiment of the present invention.

As shown in Fig. 1, the pixel arrangement structure of the OLED display includes a plurality of first pixels 100, a plurality of second pixels 200, and a plurality of third pixels 300.

According to one embodiment, the pixel refers to a minimum unit for displaying an image (for example, the minimum addressable unit of the display).

In one embodiment, power lines such as a gate line, a data line, a driving power line, and the like, are located among the first pixels 100, the second pixels 200, and the third pixels 300, for driving each of the pixels. In addition, in one embodiment, an insulation layer, such as a pixel defining layer, is provided for defining each of the pixels. Further, in one embodiment, each of the first pixels 100, the second pixels 200, and the third pixels 300 comprises an OLED including an anode, an organic emission layer, and a cathode. These configurations are technologies known in the art and further description thereof is omitted for ease of description. In one embodiment, the shape of each of the pixels is defined by the power lines, the pixel defining layer, the anode, or the like.

In the pixel arrangement of Fig. 1, each of the first pixels 100 has a smaller area (e.g., is smaller in area) than neighboring second pixels 200 and third pixels 300, and has a polygon shape. In the drawing, the first pixels 100 have an octagonal shape among the polygon shapes. In other embodiments, the first pixels 100 have one or more of various polygon shapes such as a triangle, a rectangle, a pentagon, a hexagon, a heptagon, and the like. For example, the first pixels 100 that neighbor each other among the plurality of first pixels 100 may have hexagon shapes that are symmetrical to each other. In one embodiment, each of the plurality of first pixels 100 has the same hexagonal shape.

In one embodiment, the first pixels 100 are spaced apart from each other and arranged in rows, such as along a first virtual straight line VL1. In one embodiment, the first pixels 100 emit green light, and include an organic emission layer for emitting green light. In other embodiments, the first pixels 100 include an organic emission layer that emits light of one or more of various colors such as blue, red, or white color for emitting blue light, red light, or white light.

In the drawing, the second pixels 200 are arranged diagonally with respect to the first pixels 100, namely at first vertices P1 along one diagonal of a virtual square VS having one of the first pixels 100 as a center point (or center) of the virtual square VS. In a similar fashion, in the drawing, the third pixels 300 are arranged diagonally with respect to the first pixels 100, namely at second vertices P2 along the other diagonal of the virtual square VS.

In the virtual square VS of the drawing, each of the second pixels 200 is separated from the first pixel 100, and is centered at one of the first vertices P1 of the virtual square VS. Each of the second pixels 200 has a larger area than the neighboring first pixel 100 and the neighboring third pixels 300, and has a hexagonal shape. In other embodiments, the second pixels 200 have one or more of various polygonal shapes such as a triangle, a rectangle, a pentagon, a hexagon, a heptagon, and the like.

In the drawing, the second pixels 200 each have the same hexagonal shape. In addition, the second pixels 200 are arranged diagonally and separated from each other by the first pixels 100. In one embodiment, the second pixels 200 emit blue light, and include an organic emission layer for emitting blue light. In other embodiments, the second pixels 200 include an organic emission layer that emits light of one or more of various colors such as red, green, or white for emitting red light, green light, or white light.

In a similar fashion, in the virtual square VS of the drawing, each of the third pixels 300 is separated from the first pixel 100 and the second pixels 200, and is centered at one of the second vertices P2 neighboring the first vertices P1 of the virtual square VS. Each of the third pixels 300 has a larger area than the neighboring first pixel 100 and a smaller area than the neighboring second pixels 200. The third pixels 300 preferably have a quadrilateral shape among polygon shapes. In other embodiments, the third pixels 300 may have one or more of various polygonal shapes such as a triangle, a rectangle, a pentagon, a hexagon, a heptagon, and the like.

In Fig. 1, the third pixels 300 each have the same quadrilateral shape. In addition, the third pixels 300 are arranged diagonally and separated from each other by the first pixels 100. In one embodiment, the third pixels 300 emit red light, and include an organic emission layer for emitting red light. In other embodiments, the third pixels 300 include an organic emission layer that emits light of one or more of various colors such as blue, green, or white for emitting emit blue light, green light, or white light.

In Fig. 1, each of the second pixels 200 and the third pixels 300 has a hexagonal shape and a quadrilateral shape, respectively. In another embodiment, each of the second pixels 200 and the third pixels 300 respectively has a quadrilateral shape and a hexagonal shape. That is, in this other embodiment, one of the second pixels 200 or the third pixels 300 has a hexagonal shape and the other has a quadrilateral shape.

In one embodiment, the first pixels 100, the second pixels 200, and the third pixels 300 respectively emit green light, blue light, and red light. In other embodiments, the first pixels 100, the second pixels 200, and the third pixels 300 emit light of the same color. In still other embodiments, the first pixels 100, the second pixels 200, and the third pixels 300 emit light of different colors. In some embodiments, the first pixels 100 emit green light, and one of the second pixels 200 or the third pixels 300 emit blue light while the other emit red light.

In Fig. 1, the third pixels 300 and the second pixels 200 are spaced apart from each other and alternately arranged in rows, such as along a second virtual straight line VL2. In a similar fashion, in the drawing, the third pixels 300 and the second pixels 200 are spaced apart from each other and alternately arranged in columns. Accordingly, in the virtual square VS, two of the second pixels 200 have their corresponding centers positioned at the first vertices P1 and two of the third pixels 300 have their corresponding centers positioned at the second vertices P2 to enclose a corresponding one of the first pixels 100 in the virtual square VS.

As described and illustrated in Fig. 1, the center of each of the second pixels 200 is positioned at one of the first vertices P1 of the virtual square VS. In addition, the center of the corresponding first pixel 100 is the center of the virtual square VS. Further, the center of each of the third pixels 300 is positioned at one of the second vertices P2. Therefore, the plurality of second pixels 200 of which the centers are positioned at the first vertices P1 and the plurality of third pixels 300 of which the centers are positioned at the second vertices P2 respectively enclose one of the first pixels 100 in the virtual square VS.

Further, the first pixels 100, the second pixels 200, and the third pixels 300 have polygon shapes. In Fig. 1, the distance between one of the first pixels 100 and an adjacent one of the second pixels 200 as well as a distance between one of the first pixels 100 and an adjacent one of the third pixels 300 is the same first length L1. In addition, a distance between one of the second pixels 200 and an adjacent one of the third pixels 300 is a second length L2 that is different from the first length L1. Further, in the drawing, a distance between neighboring first pixels 100 is a third length L3 that is longer than the first length L1 and the second length L2.

For example, in some embodiments, the first length L1 is between 15 µm (micrometers) and 35 µm, the second length L2 is between 20 µm and 45 µm, and the third length L3 is between 25 µm and 65 µm.

Therefore, gaps of the first length L1 are formed between adjacent pairs of the first pixels 100 and the second pixels 200, and between adjacent pairs of the first pixels 100 and the third pixels 300. In addition, the gaps of the third length L3 that is longer than the first length L1 are formed between the neighboring ones of the first pixels 100. In one embodiment, this results in improved deposition reliability in the deposition process using the fine metal mask to form the green, blue, and red organic emission layers respectively included in the first pixels 100, the second pixels 200, and the third pixels 300.

In addition, in one embodiment, the plurality of second pixels 200 and the plurality of third pixels 300 are arranged to enclose the first pixels 100 in the virtual squares VS so that an aperture ratio of each of the first pixels 100, the second pixels 200, and the third pixels 300 can be improved. Accordingly, in one embodiment, the manufacturing time and the manufacturing cost of the OLED display is reduced and the display quality of the image of the OLED display is improved.

Further, in the pixel arrangement structure of the OLED display of the drawing according to an exemplary embodiment of the present invention, the second pixels 200 that emit blue light have the shortest life span among the first pixels 100, the second pixels 200, and the third pixels 300. Accordingly, the second pixels 200 have a larger area than the first pixels 100 and the third pixels 300, thereby suppressing the deterioration of the life span of the OLED display. That is, in one embodiment, the pixel arrangement structure of the OLED display of the drawing provides improved life span.

As described above, in the pixel arrangement structure of the OLED display of Fig. 1 according to an exemplary embodiment of the present invention, the first pixels 100, the second pixels 200, and the third pixels 300 have simple polygonal shapes such as an octagon, a hexagon, and a quadrangle. In consideration of the deposition process of the organic emission layer, which in one embodiment is a unique manufacturing feature of the OLED display, a center of one of the first pixels 100 is positioned at the center of the virtual square VS, a center of one of the second pixels 200 is positioned at the first vertex P1, and a center of one of the third pixels 300 is positioned at the second vertex P2 to both improve deposition reliability of the organic emission layer in the deposition process using the fine metal mask and improve an aperture of each of the first, second, and third pixels 100, 200, and 300.

That is, according to an exemplary embodiment of the present invention as illustrated in the drawing, the pixel arrangement structure of the OLED display includes a plurality of first pixels 100 having an octagonal shape, a plurality of second pixels 200 having a hexagonal shape, and a plurality of third pixels 300 having a quadrilateral shape. In one or more embodiments, the shapes and arrangement of the first pixels 100, the second pixels 200, and the third pixels 300 improve the deposition reliability of the organic emission layer while also improving the aperture ratio of each of the first pixels 100, the second pixels, 200, and the third pixels 300.

In addition to the foregoing explanations, the following enumerated aspects, which shall not be mistaken with the attached claims, are also relevant for the present disclosure.

Aspect 1 is related to a pixel arrangement structure of an organic light emitting diode display, comprising: at least a first pixel 100 having a center coinciding with a center of a virtual square VS; at least a second pixel 200 separated from the first pixel 100 and having a center at a first vertex P1 of the virtual square VS; and at least a third pixel 300 separated from the first pixel 100 and the second pixel 200, and having a center at a second vertex P2 neighboring the first vertex P1 of the virtual square VS, wherein the first pixel 100, the second pixel 200, and the third pixel 300 have polygonal shapes, wherein the first pixel 100 has an octagonal shape, and at least one of the second pixel 200 and the third pixel 300 has a hexagonal shape.

Aspect 2. The pixel arrangement structure of aspect 1, wherein the second pixel 200 comprises a pair of second pixels 200, and the second pixels 200 are separated from each other by the first pixel 100.

Aspect 3. The pixel arrangement structure of one of the preceding aspects, wherein the third pixel 300 comprises a pair of third pixels 300, and the third pixels 300 are separated from each other by the first pixel 100.

Aspect 4. The pixel arrangement structure of one of the preceding aspects, wherein the second pixel 200 comprises a pair of second pixels 200, the third pixel 300 comprises a pair of third pixels 300, and the second pixels 200 and the third pixels 300 enclose the first pixel 100 in the virtual square VS.

Aspect 5. The pixel arrangement structure of one of the preceding aspects, wherein each of the second pixels 200 and the third pixels 300 is larger in area than the first pixel 100.

Aspect 6. The pixel arrangement structure of one of the preceding aspects, wherein one of the second pixel 200 and the third pixel 300 has a hexagonal shape and the other one of the second pixel 200 and the third pixel 300 has a quadrilateral shape.

Aspect 7. The pixel arrangement structure of aspect 6, wherein the virtual square VS comprises a pair of virtual squares VS sharing a common side, the first pixel 100 comprises a pair of first pixels 100 having centers respectively coinciding with centers of the virtual squares VS, and the first pixels 100 have octagonal shapes that are symmetrical to each other with respect to the common side of the virtual squares VS.

Aspect 8. The pixel arrangement structure of one of aspects 6 and 7, wherein each of the second pixels 200 is larger in area than each of the third pixels 300.

Aspect 9. The pixel arrangement structure of aspect 8, wherein a distance between each of the first pixels 100 and an adjacent second pixel 200 as well as a distance between each of the first pixels 100 and an adjacent third pixel 300 is a same first length L1.

Aspect 10. The pixel arrangement structure of aspect 9, wherein
the virtual square VS comprises a pair of virtual squares VS sharing a common side, the first pixel 100 comprises a pair of first pixels 100 having centers respectively coinciding with centers of the virtual squares VS , a distance between each of the second pixels 200 and an adjacent third pixel 300 is a same second length L2, and a distance between the two adjacent first pixels 100 is a third length L3 that is longer than the first length L1 and the second length L2.

Aspect 11. The pixel arrangement structure of one of the preceding aspects, wherein the first pixel 100, the second pixel 200, and the third pixel 300 are configured to emit light of different color.

Aspect 12. The pixel arrangement structure of aspect 11, wherein
the first pixel 100 is configured to emit green light, one of the second pixel 200 and the third pixel 300 is configured to emit blue light, and the other one of the second pixel 200 and the third pixel 300 is configured to emit red light.

While this invention has been described in connection with what is presently considered to be practical exemplary embodiments, it is to be understood that the invention is not limited to the disclosed embodiments, but, on the contrary, is intended to cover various modifications and equivalent arrangements included within thescope of the appended claims, and equivalents thereof.

### <Description of some symbols>

first pixel 100, second pixels 200, third pixels 300

## Claims

1. A pixel arrangement structure of an organic light emitting diode display, comprising:
a plurality of first pixels (100) each having a center coinciding with a center of a virtual square (VS); the plurality of first pixels being disposed adjacent to each other along a first direction and a second direction perpendicular to the first direction,
a plurality of second pixels (200) separated from the first pixels (100) and each having a center at a first vertex (P1) of the virtual square (VS),
wherein each of the second pixels (200) located at a first vertex (P1) of a diagonal line of the virtual square (VS) is spaced apart from a second pixel (200) located at the other vertex (P1) of the diagonal line with a first pixel (100) interposed therebetween; and
a plurality of third pixels (300) separated from the first pixels (100) and the second pixels (200), and each having a center at a second vertex (P2) neighboring the first vertex (P1) of the virtual square (VS),
wherein a distance between each of the plurality of first pixels (100) and an adjacent second pixel (200) of the plurality second pixels (200) as well as a distance between each of the plurality of first pixels (100) and an adjacent third pixel (300) of the plurality of third pixels (300) is a same first length (L1),
wherein a distance between each of the plurality of second pixels (200) and an adjacent third pixel (300) of the plurality of third pixels (300) is a same second length (L2) different from the first length (L1), and a distance between the two adjacent first pixels (100) is a third length (L3) that is longer than the first length (L1) and the second length (L2),
wherein the plurality of first pixels (100) and the plurality of second pixels (200) are alternately arranged with each other along a third direction different from the first direction and the second direction, and
wherein edges of each of the second pixels (200) are disposed on a first line in the third direction,
wherein edges of the first pixel (100) parallel to the third direction are not disposed on the first line,
wherein the plurality of first pixels (100) and the plurality of third pixels (300) are alternately arranged with each other along a fourth direction perpendicular to the third direction,
wherein edges of each of the third pixels (300) are disposed on a second line in the fourth direction,
wherein edges of the first pixel (100) parallel to the fourth direction are not disposed on the second line,
wherein a first region, which extends in the first direction and has a width in the second direction that is equal to a width of the first pixel in the second direction, does not overlap the third pixel (300), and a second region, which extends in the second direction and has a width in the first direction that is equal to the width of the first pixel in the first direction, does not overlap the third pixel (300).

2. The pixel arrangement structure of claim 1, wherein
the second pixels (200) and the third pixels (300) have different shapes from the first pixels.

3. The pixel arrangement structure of claim 1 or 2, wherein
the first region does not overlap the second pixel (200) and the second region does not overlap the second pixel (200).

4. The pixel arrangement structure of any of the preceding claims, wherein the third pixels (300) are separated from each other by a first pixel (100).

5. The pixel arrangement structure of any of the preceding claims, wherein
the second pixels (200) and the third pixels (300) enclose a first pixel (100) in the virtual square (VS).

6. The pixel arrangement structure of any of the preceding claims, wherein the pixel arrangement comprises:
a pair of virtual squares (VS) sharing a common side, and
a pair of first pixels (100) having centers respectively coinciding with centers of the virtual squares (VS).

7. The pixel arrangement structure of claim 6, wherein The first pixel (100) the first pixels has a convex shape with no vertex angle of 90 degrees.

8. The pixel arrangement structure of any of the preceding claims, wherein
one of the first pixels (100) has two parallel edges extending in the third direction or fourth direction, and a connection portion connecting ends of the two parallel, and
wherein a length of the connection portion is longer than the shortest distance between the two parallel edges.

9. The pixel arrangement structure of claim 8, wherein
the connection portion is symmetric with respect to a line extending in the third direction or the fourth direction that passes through a center of the first pixel (100).

10. The pixel arrangement structure of any of the preceding claims, wherein
wherein one of the first pixels (100) comprises a first end portion, a center portion, and a second end portion arranged along the third or fourth direction,
wherein a width of each of the first and second end portions gradually decreases from the center portion towards respective ends of the one of the first pixels (100) along the third or fourth direction.

11. The pixel arrangement structure of any of the preceding claims, wherein
each of the first pixels (100) has a convex shape such that a line bisecting the first pixel (100) along a long axis thereof has a greater length than a line bisecting the first pixel along short axis thereof.

12. The pixel arrangement structure of any of the preceding claims, wherein each of the second pixels (200) is larger in area than each of the third pixels (300).

13. The pixel arrangement structure of any of the preceding claims, wherein
the first pixels (100), the second pixels (200), and the third pixels (300) are configured to emit light of different color.

14. The pixel arrangement structure of claim 13, wherein
the first pixels (100) are configured to emit green light,
either the second pixels (200) or the third pixels (300) are each configured to emit blue light, and
the other one of the second pixels (200) or the third pixels (300) are each configured to emit red light.

15. The pixel arrangement structure of any of the preceding claims, wherein
a shortest distance (L3) between two nearest ones of the first pixels (100) in the first direction is greater than a width in the first direction of one of the third pixels (300).

16. The pixel arrangement structure of any of the preceding claims, wherein
one of the first pixels (100) is symmetric with respect to a line extending in the third direction or the fourth direction that passes through a center of the first pixel.

17. The pixel arrangement structure of any of the preceding claims, wherein
wherein a pair of first pixels (100) on respective sides of one of the second pixels (200) in the third direction or the fourth direction are symmetric with each other with respect to the one of the second pixels (200), and
wherein a pair of first pixels (100) on respective sides of one of the third pixels in the third direction or the fourth direction are symmetric with each other with respect to the one of the third pixels (300).

18. The pixel arrangement structure of any of the preceding claims, wherein
a line bisecting a long axis of the first pixel passes through a center of the first pixel (100), and
a line bisecting a short axis of the first pixel passes through a center of the first pixel (100).

19. The pixel arrangement structure of any of the preceding claims, wherein
any two of the first pixels (100) that are immediately adjacent to each other have different maximum widths in the third direction, and
any two of the first pixels (100) that are immediately adjacent to each other have different maximum widths in the fourth direction.
